# EUROPEAN PATENT APPLICATION

(11) **EP 4 842 196 A1**
(43) Date of publication of application: **18.11.2026**
(21) Application number: 26178724.6
(22) Date of filing: 13.05.2026
(51) Int. Cl.: H10W 90/00, H10W 70/654, H10W 72/20, H05K 3/341

(54) **A BGA PACKAGED SEMICONDUCTOR DEVICE**

(30) Priority: 14.05.2025 CN 202510621794
(71) Applicant: NXP USA, Inc, Austin, TX 78735 (US)
(72) Inventor: Ge, You, 5656AG Eindhoven (NL); Job Doraisamy, Stanley, 5656AG Eindhoven (NL); Hosoda, Daisuke, 5656AG Eindhoven (NL); Wang, Zhijie, 5656AG Eindhoven (NL); Lee, Yit Meng, 5656AG Eindhoven (NL)
(74) Representative: Schwarzweller, Thomas

(57) **Abstract**

Aspects of this disclosure are directed to a ball grid array, BGA, packaged semiconductor device comprising: a semiconductor die; a substrate, to a first surface of which the semiconductor die is affixed, and having a first and a second subarrays of contact pads on a second surface thereof opposite the first surface, wherein at least some of the contact pads are electrically connected to the semiconductor die; molding compound, on the first surface of the substrate and encapsulating the semiconductor die; first and second subarrays of solder balls, each solder ball affixed to a respective contact pad; and a polymer material on the second surface of the substrate and between the subarrays of solder balls. Corresponding methods are also disclosed.

## Description

### FIELD OF THE DISCLOSURE

This present disclosure relates to ball grid array (BGA) packaged semiconductor devices, and method of assembling the same.

### BACKGROUND

Ball grid array (BGA) packaging technology is a widely used surface mount technology (SMT), in which a semiconductor package includes a plurality of solder balls, arranged in a rectangular grid, on a bottom or lower surface of the package. Compared with other packaging technologies, it is generally area-efficient. For some applications, it may not be appropriate, or even possible to have a complete rectangular grid of solder balls. For example, in some semiconductor devices, it may be required to separate high-voltage connection, such as high-voltage input/output (I/O) pins from low-voltage I/O pins. Particularly for high-voltage devices, with a small pitch of the grid, it may be necessary to leave gaps in the grid so as to provide for an appropriate level of galvanic isolation between the high-voltage and low-voltage I/O pins. One, nonlimiting, type of device to which this applies is the so-called GILC (galvanically isolated communication link) class of devices. The missing balls from the grid, and the relatively large separation between neighboring solder balls, can provide at least two challenges. Firstly, the gaps may result in warpage, or a nonplanar soldered lower surface, which in turn can result in a reduction in the reliability of electrical connections to the solder balls. This may be evidenced by a reduced board level reliability (BLR) for the device type. And secondly, the physical separation required to provide appropriate for galvanic isolation can result in the package device being larger than would otherwise be the case, which in turn may result in a larger cost of the bill of materials for the package device.

### SUMMARY

According to a fist aspect of the present disclosure, there is provided a ball grid array, BGA, packaged semiconductor device comprising: a semiconductor die;
a substrate, to a first surface of which the semiconductor die is affixed, and having a first and a second subarrays of contact pads on a second surface thereof opposite the first surface, wherein at least some of the contact pads are electrically connected to the semiconductor die; molding compound, on the first surface of the substrate and encapsulating the semiconductor die; first and second subarrays of solder balls, each solder ball affixed to a respective contact pad; and a polymer material on the second surface of the substrate and between the subarrays of solder balls. Provision of a polymer material on the second surface of the substrate between subarrays of solder balls may provide improved galvanic isolation between the subarrays; it may further provide increased mechanical rigidity of the device, which may in turn improve board level reliability. Moreover, it may assist in balancing different coefficient of thermal expansions (CTE) between components of the package device, which in turn may improve the thermal and mechanical performance, and in particular, may reduce thermally induced warping during temperature cycled

In one or more embodiments, the polymer material is polyurethane. The polymer material may further include an additional layer of a polyimide material. Polyimide has adhesion properties which allow it to adhere to the substrate.

In one or more embodiments, the polymer material comprises one or a plurality of discrete patches. Applying one or more discrete patches may be particularly convenient method of assembly. The size of the patches may be used chosen to suit the application.

In one or more other embodiments the polymer material comprises a plurality of polymer balls, in an array having a same pitch as a pitch of the solder balls in the subarrays. By generally mirroring the footprint of individual solder balls, the mechanical integrity of the device may be improved. Thus, in one or more such embodiments the polymer balls have a same diameter as the solder balls.

In one or more embodiments, a thickness of the polymer material is equal to a sum, or slightly larger, typically within 10%, or 20% of the combined thickness of the contact pads and the solder balls. The polymer material may then provide contact between the package device and a circuit board. Once the package device is mounted. This may improve the mechanical strength of the device on the circuit board.

In one or more embodiments, the first subarray of solder balls is for providing high-voltage input/output, IO, connections to the semiconductor die, and the second subarray of solder balls is for providing low-voltage IO connections to the semiconductor die, and a minimum distance between the first subarray and the second subarray is at least an isolation separation. In one or more such embodiments, the isolation separation is dependent on a dielectric constant of the polymer material.

In one or more embodiments, at least one of the first and second subarrays comprises one or more gaps therein, having polymer material therein. In one or more such embodiments, the polymer material in the gaps comprises a plurality of balls having both a same pitch and a same diameter as the solder balls, and forming a continuous array therewith.

In one or more embodiments a thickness of the polymer material is between 100% and 125% of a diameter of the solder balls. The thickness might be chosen so as to ensure that, in use, the polymer material fills the gap between the substrate and a PCB to which the packaged semiconductor device is to be bonded and in contact with both the substrate and the PCB, whilst providing for solder bonds between the solder balls and contact pads of contact tracks on the PCB.

According to a second aspect of the present disclosure, there is provided a method of assembling a BGA packaged semiconductor device, the method comprising: attaching a semiconductor die to a substrate; encapsulating the semiconductor die on the substrate; attaching a first subarray and a second subarray of solder balls to contact pads on a rear side of the substrate; and affixing a polymer material to the rear side of the substrate between the first subarray and second subarray of solder balls.

In one or more embodiments the polymer material is polyurethane.

In one or more embodiments the polymer material comprises an adhesive layer, and affixing the polymer material to the rear side of the substrate comprises bonding the adhesive layer to the substrate. The adhesive layer may be polyimide.

In one or more embodiments the polymer material fills, or substantially fills, an isolation gap between the first subarray and second subarray of solder balls

### BRIEF DESCRIPTION OF THE DRAWINGS

Reference will now be made to the accompanying drawings, in which:
FIG. 1 illustrates a bottom view of a BGA packaged semiconductor device 100;
FIG. 2 illustrates a bottom view of another BGA packaged semiconductor device 200;
FIG. 3 illustrates a bottom view of a BGA packaged semiconductor device 300 according to embodiments of the present disclosure;
FIG. 4 shows a schematic section through the BGA packaged semiconductor device of FIG. 3;
FIG. 5 illustrates a bottom view of a BGA packaged semiconductor device 300 according to other embodiments of the present disclosure;
FIG. 6 shows a schematic section through the BGA packaged semiconductor device of FIG. 5;
FIG. 7 shows a schematic section through the BGA packaged semiconductor device of FIG. 5 prior to mounting on a PCB;
FIG. 8 illustrates a bottom view of a BGA packaged semiconductor device 300 according to other embodiments of the present disclosure;
FIG. 9 shows a schematic section through the BGA packaged semiconductor device of FIG. 8; and
FIG. 10 shows a flowchart of a method according to embodiments of the present disclosure

It should be noted that the FIG.s are diagrammatic and not drawn to scale. Relative dimensions and proportions of parts of these FIG.s have been shown exaggerated or reduced in size, for the sake of clarity and convenience in the drawings. The same reference signs are generally used to refer to corresponding or similar features in modified and different embodiments.

### DETAILED DESCRIPTION

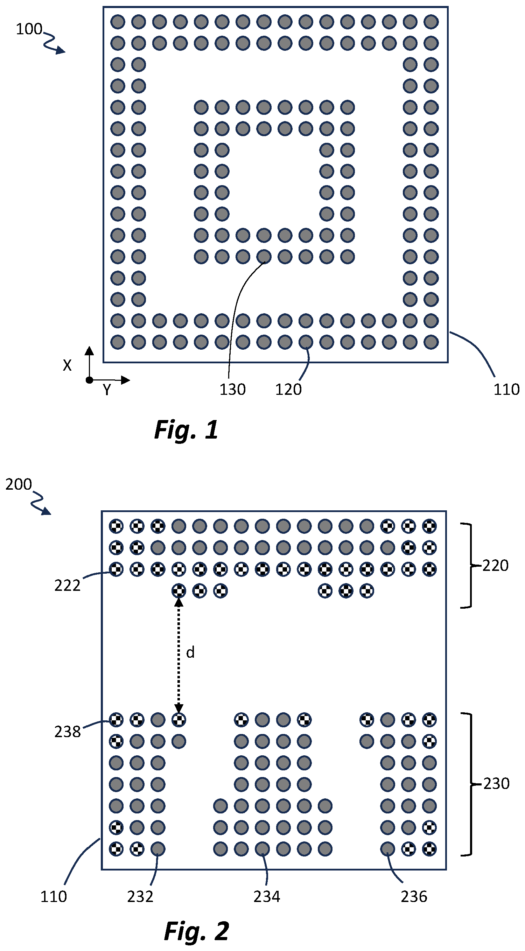

FIG. 1 shows, schematically, a bottom view of a BGA packaged semiconductor device 100. In particular, the FIG. shows the outline 110 of the device package, and a plurality of solder balls 120, 130. The solder balls are arranged in one or more rectilinear grids. As shown, BGA packaged devices typically include an outer group or subarray of solder balls 120, generally around and near to the perimeter of the device, and an inner group or subarray of solder balls 130, generally closer to a central region of the packaged device. The solder balls are designed to provide electrical connections to metallized tracks on a PCB to which the BGA device will be fixed. As shown, to provide for simple PCB design the inner 130 and outer 120 groups are typically aligned to the same rectangular grid. By rectilinear in this context is meant that the grid is rectangular, with a common pitch in both X and Y directions (that is to say across and along the device).

FIG. 2 shows, schematically, a bottom view of another BGA packaged semiconductor device 200. Similar to the BGA packaged semiconductor device 100, this device has a plurality of solder balls arranged in an incomplete rectangular grid. The balls are arranged in two overall groups or subarrays. A first subarray 220 is located towards one side of the device 200; a second subarray 230 is located towards an opposite side of the device. This type of arrangement is often used in devices which require galvanic isolation between two groups of contacts and thus between two groups of solder balls. One example of such a type of device are so-called GICL (galvanically isolated communication link) devices. Such devices have a first set of I/Os (input/outputs) which are low-voltage I/Os or I/Os in a low-voltage domain, and a second set of diodes which are high-voltage I/Os or I/Os in a high-voltage domain. The first set of I/Os corresponds to the group or subarray of solder balls 220, or to a subset of those solder balls. The second set of I/Os corresponds to the group or subarray of solder balls 230, or to a subset of those solder balls. The two groups or subarrays are separated by at least a distance d. A minimum value of the distance d is typically specified in the design rules of the device, in order to ensure an appropriate level of galvanic isolation between the high-voltage and low-voltage I/Os, to prevent arcing between the respective solder balls. The skilled person will be aware that in such arrangements, some of each of the subarrays 230 and 220 of solder balls may be so-called "dummy" balls 222 and 238, that is to say they are not electrically connected to the semiconductor device within the package. The dummy solder balls may be used to provide a degree of shielding for active I/O signals, in either or both the high-voltage and low-voltage domains. They also may serve a secondary purpose of providing increased mechanical stability for the device. Nonetheless, design rules typically preclude including dummy solder balls in the isolation region provided by the separation or gap d. Furthermore, one or both of the subarrays may be further separated into subgroups - such as that shown by solder balls 232, 234, 236

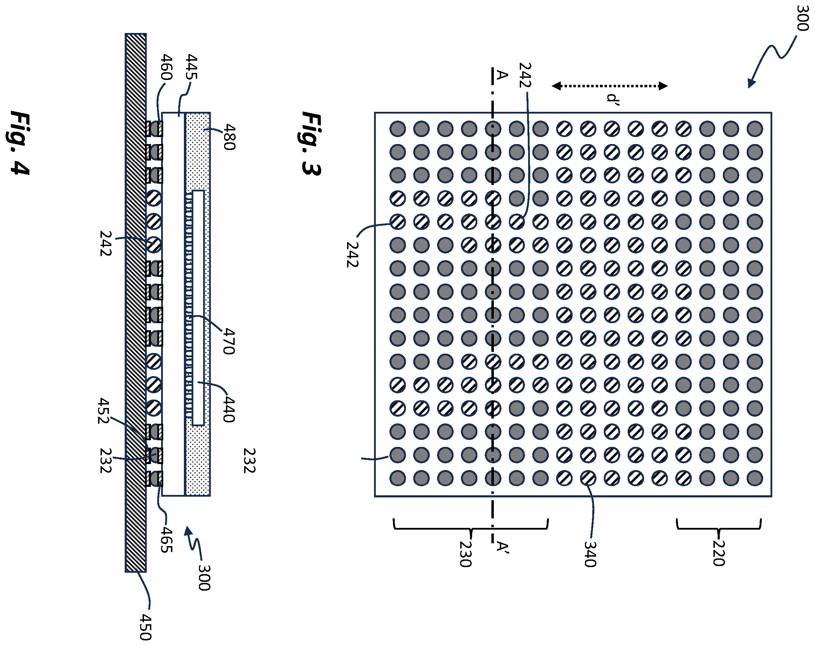

Turning to FIG. 3, this shows, schematically, a bottom view of a BGA packaged semiconductor device 300 according to embodiments of the present disclosure. The FIG. shows the same first subarray of solder balls 220, and second subarray 230, spaced apart by a distance d'. For ease of understanding, the or any dummy solder balls are not separately indicated. In addition to the first and second subarray of solder balls, there can be seen polymer discs or polymer balls 340 positioned in in the rectilinear grid where there is not a solder ball. As shown, the polymer discs or polymer balls may occupy all the grid locations in which there is not a solder ball 220 or 230; in other embodiments, the polymer discs or polymer balls may occupy only some of the grid locations.

As can be seen in the FIG., one or both the subarrays of low-voltage solder balls 220 and high-voltage solder balls 230 may be incomplete in the sense that there are gaps in the grid, in which there is no solder ball. In other words, instead of being a rectangular grid in which all the grid positions have a corresponding solder ball, one or both the subarrays of low-voltage solder balls and high-voltage solder balls may be a rectilinear polygon with "missing" solder balls around the perimeter of a generally rectangular shape. Alternatively, one or both of the subarrays may be split into separate rectilinear parts. Such as the subarray 230 shown in FIG. 3. In the example shown, the high-voltage subarray 230 is incomplete. The gaps in the array of low-voltage or high-voltage solder balls may be occupied by polymer discs or polymer balls, such as the polymer ball 242 shown.

The polymer discs or polymer balls are typically an elastomer material. A particularly suitable elastomer material for use as the polymer discs or polymer balls 340 is polyurethane. Polyurethane has particularly suitable thermal properties, is suitable for reflow because of its softening and melting temperature, and is also elastomeric, and nonconductive. One, non-limiting, alternative to polyurethane is polyimide.

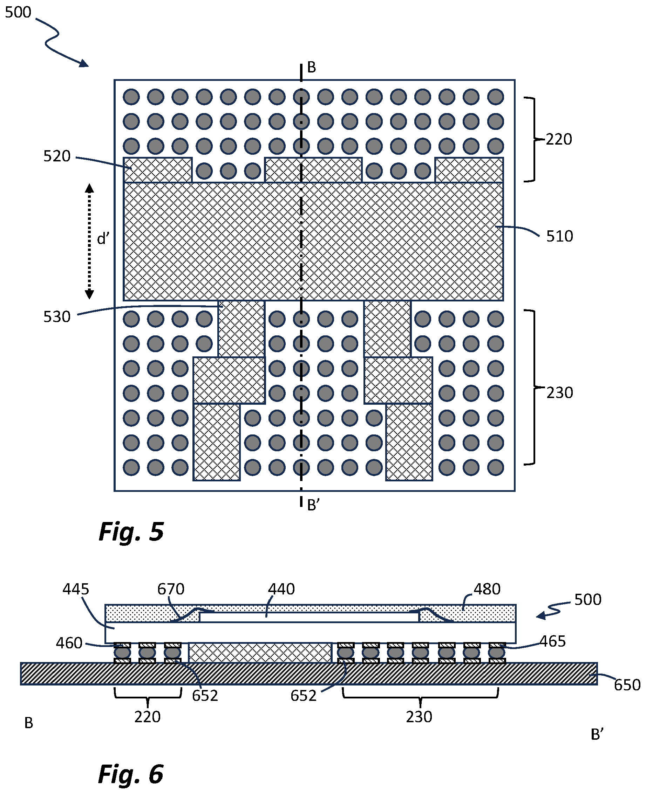

Turning to FIG. 4, this shows a schematic section AA' through the BGA packaged semiconductor device 300, mounted on a PCB 450. The solder balls, such as solder ball 232 of the BGA array, provide electrical connection to circuits or tracks 452 on the PCB, as will be familiar to the skilled person. In the grid locations where there are not solder balls, the polymer discs or polymer balls, 242 at least partially fill the space between the substrate of the BGA packaged semiconductor device 300 and the PCB 450. In addition to the features visible in FIG. 3, FIG. 4 also shows the semiconductor die 440; a substrate 445, to a first surface of which the semiconductor die is affixed, and having a first 460 and a second 465 subarrays of contact pads on a second surface thereof opposite the first surface, wherein at least some of the contact pads are electrically connected to the semiconductor die (for example by electric tracks or vias through the substrate - not shown, and, in this example, bump bonds 470). The semiconductor die may be electrically and mechanically connected to the substrate by any one a variety of known techniques, such as flip chip bonding as shown in FIG. 4, wire bonding as will be shown in FIG. 6, or other known assembly techniques. Encapsulant or molding compound 480 is provided on the first surface of the substrate and encapsulating the semiconductor die. The encapsulation may be carried out by any one of a variety of known techniques. For example, a mold array process (MAP) may be used in which an array of the semiconductor die are bonded onto a continuous sheet of the substrate material 445; the array of semiconductor die are then encapsulated in a single process. The array of package devices are then singulated at a later stage of the process (for example, after applying the solder balls and polymer discs or polymer balls). However, the disclosure is not limited to mold array processes, but may be applied on a wide range of different package type including, without limitation, QFP ("Quad Flat Package"), QFN ("Quad Flat No-Lead Package") SOIC ("Small Outline IC"), or the like.

The thickness of the polymer material 510 is generally similar to the diameter of the solder balls, such that, once assembled onto a PCB, the polymer is in contact with, on one surface, the substrate, and on the other surface the PCB. The polymer material 510 may include an adhesive layer configured to adhere the polymer to the substrate during assembly process. For example, the solder balls might have a diameter or thickness of 0.33mm, leading to a final stand-off of approximately 0.22mm after ball-attach and reflowing, and the polymer material (including the optional adhesive layer, where appropriate), may have a thickness of 0.25mm.

By providing the polymer material, and in particular using an elastomer such as polyurethane between the solder balls, the mechanical properties of the device may be improved. For example, the polymer balls or discs 242 may provide cushioning between the substrate and the PCB, which may reduce warpage of the device. In turn this may improve the board level reliability (BLR) of the device in use. Moreover, materials such as polyurethane typically soften at a relatively low temperature. For example, the so-called "Vicat" softening point of polyurethane usually falls within the temperature range of 50° to 130°C. In consequence, the polyurethane softens and/or reflows during the surface mount operation of the device onto the PCB. During the process, the material may thus "reflow" to some extent, and may spread towards or even around some or all of the solder balls. For example, some polyurethane may remain between the package bottom side and the PCB top surface to enhance adhesion of the two surface, and some may surround the solder balls, depending on the total polyurethane total volume. By providing a material which can to some extent infill the gap between the two subarrays of solder balls, increased thermomechanical stability may be provided. Whereas there is a significant mismatch between the coefficient of thermal expansion (CTE) of the polymer such as polyurethane and the solder balls, the presence of a polymer and in particular a polymer underneath the substrate may balance match the mismatch between the semiconductor and the in capsule and molding material.

Furthermore, by providing a polymer material such as polyurethane between the solder balls, and in particular between high-voltage solder balls and low-voltage solder balls, the galvanic isolation is enhanced. In particular, since polymer materials such as polyurethane have a resistivity which is greater than that of air, an equivalent level of galvanic isolation, may be provided over a small distance d'. In other words, the same stand-off voltage below which arcing will not occur may be provided with a smaller physical separation between the high-voltage and low-voltage solder balls. The overall size of the BGA packaged semiconductor device 300 may thus be smaller than would otherwise be the case, which represents a smaller bill of materials and thus a cost saving.

FIG. 5 shows, schematically, a bottom view of a BGA packaged semiconductor device 500 according to other embodiments of the present disclosure. The FIG. again shows the first subarray of solder balls 220, and second subarray 230, spaced apart by a distance d'. Again, for ease of understanding, the or any dummy solder balls are not separately indicated. In addition to the first and second subarray of solder balls, are shown sheets 510, 520, 530, or inserts, of polymer material such as polyurethane. There may be a single sheet, or as shown, there may be several sheets which either abut each other or are contiguous, or there may be several sheets which are spaced apart. In applications such as GICL devices having high-voltage I/Os and low-voltage I/Os, the material may include at least a main sheet 510 which fills at least most of the isolation gap d' between high-voltage solder balls 230 and low-voltage solder balls. Gaps in the subarray of low-voltage solder balls may be filled by subsidiary sheets, such as sheet 520 shown, and, or in the alternative, gaps in the subarray of high-voltage solder balls may be filled by subsidiary sheets, such as 530, shown.

FIG. 6 shows a schematic cross-section BB' through the device 500, mounted onto a PCB 650. The FIG. shows the first subarray of solder balls 220, for providing low-voltage I/Os between the device and the PCB, and in particular to conductive tracks or traces 652, and the second subarray of solder balls 234 providing high-voltage I/Os between the device and the PCB and in particular to other conductive tracks or traces 652. Filling most of the gap between the high-voltage solder balls and low-voltage solder balls is a sheet or insert of polymer such as polyurethane 510. FIG. 6 shows an alternative package type to that shown in FIG. 4 In FIG. 6 the semiconductor die is wire bonded to the substrate

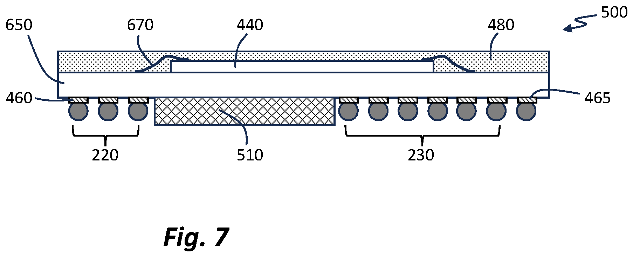

FIG. 7 shows the schematic cross-section BB' through the device 500 prior to being mounted onto a PCB. Since the device 500 has not yet been mounted onto the PCB, the solder balls 220 and 230 have not been "squashed" or flattened by the soldering process. None-the-less, the polymer sheet 510 still extends below the lower surface of the solder balls, since during PCB mounting, the solder balls will make contact with the contact pads (together, optionally, with solder paste or flux on the contact pads) which is a raise surface, relative to the remainder of the PCB, as can be seen in FIG. 6. Thus, FIG. 7 illustrates a ball grid array, BGA, packaged semiconductor device 500 comprising: a semiconductor die 440; a substrate 445, to a first surface of which the semiconductor die is affixed, and having a first 460 and a second 465 subarrays of contact pads on a second surface thereof opposite the first surface, wherein at least some of the contact pads are electrically connected to the semiconductor die (for example by electric tracks of buyers through the substrate - not shown, and bond wires 670, or bump bonds 470); molding compound 480, on the first surface of the substrate and encapsulating the semiconductor die; first 220 and second 230 subarrays of solder balls, each solder ball affixed to a respective contact pad; and a polymer material 510 on the second surface of the substrate and between the subarrays of solder balls.

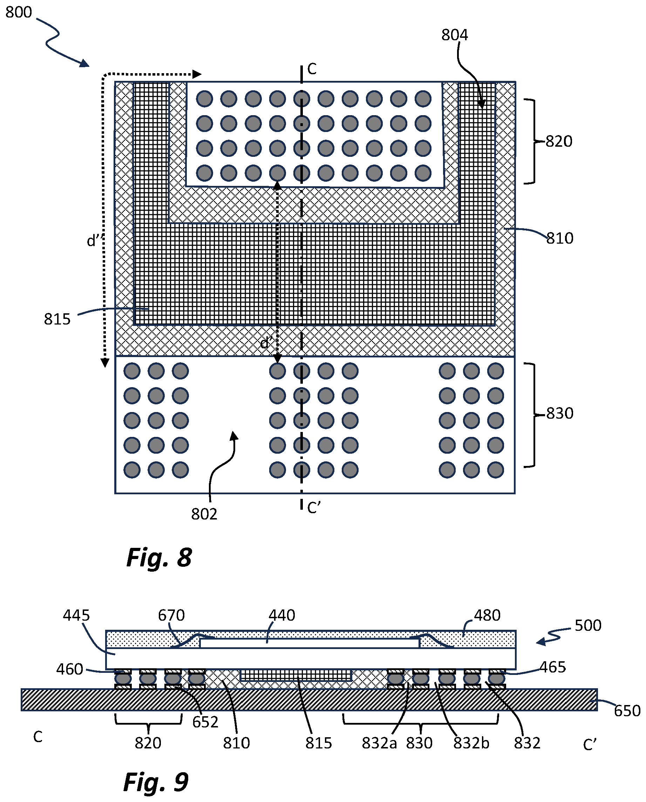

FIG. 8 shows, schematically, a partially schematic bottom view of a BGA packaged semiconductor device 800 according to other embodiments of the present disclosure. The FIG. shows a first subarray of solder balls 820, and a second subarray 830, spaced apart from the first subarray of solder balls 820. Again, for ease of understanding, the or any dummy solder balls are not separately indicated. In addition to the first and second subarray of solder balls, is shown a sheet 810 of polymer material such as polyurethane. In additional to occupying most of the space between the subarrays, the sheet may as shown, or may not, fill spaces or gap within or around the subarrays. Thus as shown, the sheet may or may not occupy spaces such as 802 between or around groups of high-voltage solder balls, and similarly may or may not occupy spaces such as 804 between or around groups of low-voltage solder balls. In addition to the sheet 810 of polymer material such as polyurethane, there is also included an additional sheet 815 of a second polymer material. The additional, second, sheet 815 may be polyimide material, also referred to as Kapton ^{®}. Polyimide is particularly convenient for use as this additional second sheet, due to its adhesion properties and suitable softening and melting points. It should be noted that although the additional polymer sheet 815 is shown in the partially schematic FIG. 8, it would not be visible in a literal "bottom view", but would be obscured, since it is arranged between the first polymer sheet 810 and the semiconductor package substrate 445, as will be explained in more detail with reference to FIG. 9. The material of the second polymer sheet 815 should have a higher melting point and softening point than that of first polymer sheet 810 such that, during the reflow process in which the polymer sheet 810 may reflow and spread for example, to fill spaces between solder balls, the second polymer sheet 815 does not reflow. As shown, the additional polymer sheet, which may also be referred to as an additional polymer layer or a second polymer layer is generally smaller than the first polymer sheet 810. That is to say, the first polymer sheet extends beyond the additional polymer sheet 815 and at least partially or completely surrounds it, laterally across the device.

FIG. 9 shows a schematic cross-section CC' through the device 800, mounted onto a PCB 650. Except for the arrangement of the first and second subarrays of solder balls 820, 830, and the inclusion of the second polymer sheet 815 such as polyimide in addition to the first polymer sheet 810, such as polyurethane, the figure is similar to the cross-section shown in FIG. 6. In embodiments such as that shown in FIG. 9, the first polymer sheet may reflow or spread to fill some or all of the spaces 832 between the solder balls. In the example shown, the first polymer sheet has reflowed to an extent, to fill in the space 832a but not as far as to fill in the space 832b. Since the polymer sheets have a higher stand-off voltage against arcing than does air, the minimum separation d' between the high-voltage solder balls and low-voltage solder balls may be less than is generally required for conventional devices. Furthermore, in embodiments such as that shown, the closest route through the air for potential arcing, d", is considerably longer than the minimum separation distance d' in a nonlimiting example, the minimum separation distance d' may be, for example, 4mm, whereas the closest route d" through the air may be, for example, 10mm

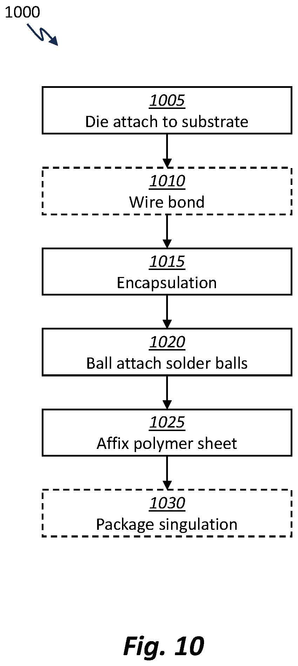

FIG. 10 shows a flowchart 1000 of a method of assembly of a BGA packaged semiconductor device such as that shown in FIG. 4, comprising a polymer sheet such as polyurethane sheet to provide the increased resistivity and improved BLR. The method comprises as a first step 1005, "die attach to substrate", in which the semiconductor is bonded, by conventional means, to the substrate. The conventional means may, as indicated above include flip chip bonding or other known processes. Optionally, the method may include 1010 "wire bonds", which comprises providing wire bonds between contacts on a top surface of the semiconductor die and metal tracks or redistribution layers on, or partially in, the substrate. The method then includes an "encapsulation" step 1015, in which one, or an array of semiconductor die are encapsulated on the substrate, using an encapsulant such as molding compound 480. There then follows a step 1020 ("ball attach solder balls"), in which solder balls are attached to the rear side of the substrate for example, by means of 3 tools. A first tool may be used to drop a flux dot or point onto the substrate pads in each ball location. A second tool makes a solder ball array with N x M balls, the pitch and positions of which matches the substrate pads' location. A third tool sucks all the solder balls at same time and puts them onto the flux dot or point. Then, after a reflow process, the solder balls will attach onto substrate. The polymer material is then affixed to the rear side of the substrate, between the solder balls, in step 1025 ("affixing polymer sheet"). The method may include a further optional step 1030 ("package simulation"), particularly in the event that the encapsulation or molding process is carried out at the array level.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. FIG.s are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A ball grid array, BGA, packaged semiconductor device comprising:
a semiconductor die;
a substrate, to a first surface of which the semiconductor die is affixed, and having a first and a second subarray of contact pads on a second surface thereof opposite the first surface, wherein at least some of the contact pads are electrically connected to the semiconductor die;
molding compound, on the first surface of the substrate and encapsulating the semiconductor die;
first and second subarrays of solder balls, each solder ball affixed to a respective contact pad; and
a polymer material on the second surface of the substrate and between the subarrays of solder balls.

2. The BGA packaged semiconductor device of claim 1, wherein
the polymer material is polyurethane.

3. The BGA packaged semiconductor device of claim 1 or 2, wherein
the polymer material further includes an additional layer of a polyimide material.

4. The BGA packaged semiconductor device of any preceding claim,
wherein the polymer material comprises a plurality of discrete patches.

5. The BGA packaged semiconductor device of any of claims 1 to 3,
wherein the polymer material comprises a plurality of polymer balls, in an array having a same pitch as a pitch of the solder balls in the subarrays.

6. The BGA packaged semiconductor device of claim 5,
wherein the polymer balls have a same diameter as the solder balls.

7. The BGA packaged semiconductor device of any preceding claim, wherein
a thickness of the polymer material is equal, or larger than by no more than 10%, to a sum of the thickness of the contact pads and the solder balls.

8. The BGA packaged semiconductor device of any preceding claim, wherein
the first subarray of solder balls is for providing high-voltage input/output, IO, connections to the semiconductor die, and the second subarray of solder balls is for providing low-voltage IO connections to the semiconductor die, and a minimum distance between the first subarray and the second subarray is at least an isolation separation.

9. The BGA packaged semiconductor device of claim 8, wherein
the isolation separation is dependent on a dielectric constant of the polymer material.

10. The BGA packaged semiconductor device of any preceding claim, wherein
at least one of the first and second subarrays comprises one or more gaps therein, having polymer material therein.

11. The BGA packaged semiconductor device of any preceding claim, wherein
a thickness of the polymer material is between 100% and 125% of a diameter of the solder balls.

12. A method of assembling a BGA packaged semiconductor device, the method comprising:
attaching a semiconductor die to a substrate;
encapsulating the semiconductor die on the substrate;
attaching a first subarray and a second subarray of solder balls to contact pads on a rear side of the substrate; and
affixing a polymer material to the rear side of the substrate between the first subarray and second subarray of solder balls.

13. The method of claim 12, wherein
the polymer material is polyurethane.

14. The method of claim 12 or 13, wherein
the polymer material comprises an adhesive layer,
and affixing the polymer material to the rear side of the substrate comprises bonding the adhesive layer to the substrate.

15. The method of any of claims 12 to 14 wherein
the polymer material fills, or substantially fills, an isolation gap between the first subarray and second subarray of solder balls.
